# EUROPEAN PATENT APPLICATION

(11) **EP 0 568 446 A1**
(43) Date of publication of application: **03.11.1993**
(21) Application number: 93401093.5
(22) Date of filing: 27.04.1993
(51) Int. Cl.: C23C 14/08, C23C 14/28, C23C 14/34

(54) **Process for depositing a compound oxide superconducting thin film**

(30) Priority: 27.04.1992 JP 134246/92
(71) Applicant: Sumitomo Electric Industries, Ltd., Osaka 541 (JP)
(72) Inventor: Nagatshi, Tatsuoki, c/o Itami Works of Sumitomo, Itami-shi, Hyogo (JP); Itozaki, Hideo, c/o Itami Works of Sumitomo, Itami-shi, Hyogo (JP)
(74) Representative: Hasenrader, Hubert

(57) **Abstract**

The invention deals with a process for depositing a compound oxide superconducting thin film in a physical vapor deposition process.

According to the invention, a compound oxide superconducting thin film is deposited by a laser deposition while irradiating an auxiliary laser beam (8A) passing in the vicinity of the deposition surface (4A) of the substrate (4), in parallel to the deposition surface (4A).

Thus, a compound oxide superconducting thin film having a good superconducting property can be deposited at a low substrate temperature.

## Description

### Background of the Invention

### Field of the invention

The present invention relates to a process for depositing an oxide superconducting thin film, and more particularly to a novel process which enables to deposit at a lower substrate temperature a superconducting thin film having a good superconducting property, of a compound oxide, for example, a copper-oxide type compound oxide such as Y type compound oxide.

### Description of related art

The superconducting phenomenon had been considered as an intrinsic phenomenon at an extremely low temperature which needs the cooling by liquid helium. However, since Bednorz and Müller found [La, Ba]₂CuO₄ showing a superconducting state at 30°K, YBa₂CU₃O_{y} having a superconducting critical temperature T_{C} on the order of 90°K was discovered by Chu et at in 1987, and then, a so-called Bi system compound oxide superconducting material having a critical temperature of not less than 100°K was discovered by Maeda et al in 1988. A series of these compound oxide superconductor materials can show the superconducting phenomenon by cooling them by means of cheap liquid nitrogen, and therefore, possibility of practical application of the superconducting technique has become much discussed recently.

At the outset, these compound oxide superconductors were synthesized as a sintered material by a solid phase reaction. Thereafter, it has become possible to prepare them as a very high-quality thin film because of the development of researches.

A series of compound oxide superconductors as mentioned above have remarkable crystal anisotropy in its superconducting properties. Namely, the compound oxide superconductors can flow a greater electric current in a direction perpendicular to the c-axis of the crystal. Thus, in the case of depositing a compound oxide superconducting thin film, it is necessary to control the crystalline orientation of the thin film, considering a propagation direction of the superconducting current in a final application.

For example, if a first superconducting thin film, a non-superconducting layer and a second superconducting thin film are deposited on a substrate in the named order so as to form a Josephson junction, it is preferable to use an *a*-axis or *b*-axis oriented thin film in which a superconducting current tends to flow perpendicularly to the substrate. In general, it is known that the *a*-axis or *b*-axis oriented compound oxide superconducting thin film is formed by maintaining the substrate temperature at a low temperature in the course of a film deposition. In this specification, the "*a*-axis oriented thin film" means a thin film in which the *a*-axis of the crystal is oriented perpendicularly to the deposition surface of the substrate, and the *b*-axis oriented thin film" means a thin film in which the *b*-axis of the crystal is oriented perpendicularly to the deposition surface of the substrate.

As described above, the *a*-axis or *b-*axis oriented compound oxide superconducting thin film is formed by maintaining a substrate temperature at a low temperature in the course of the film deposition. However, the superconducting property has been coiifirmed that the superconducting critical temperature of the *a*-axis or *b*-axis oriented thin film actually produced is remarkably lower than that of a *c*-axis oriented thin film produced at a standard substrate temperature.

### Summary of the Invention

Accordingly, it is an object of the present invention to provide a novel process for depositing a thin film, which has overcome the above mentioned defect of the conventional one.

Another object of the present invention is to provide a novel process for depositing a thin film, which enables to deposit an *a*-axis or *b*-axis oriented thin film having a good superconducting property such as a high critical temperature.

The above and other objects of the present invention are achieved in accordance with the present invention by a process for depositing a compound oxide superconducting thin film in a physical vapor deposition process, including the step of depositing a film on a deposition surface of a substrate in an oxygen atmosphere, while passing an auxiliary laser beam in the vicinity of the deposition surface of the substrate, in parallel to the deposition surface of the substrate.

In a typical example, the compound oxide superconducting thin film is formed of a high critical temperature (high-Tc) copper-oxide type oxide superconductor material, which can be typified by a Y-Ba-Cu-O type compound oxide superconductor material.

As will be seen from the above, the process in accordance with the present invention for depositing a compound oxide superconducting thin film is essentially characterized in that an auxiliary laser passing in the vicinity of the deposition surface of the substrate is used in the deposition process of the compound oxide superconductor thin film based on the laser evaporation.

As the results of considering the conventional deposition process in detail, the following point has been clarified: Namely, in the case of depositing a compound oxide superconducting thin film at a low substrate temperature in accordance with the conventional process in order to form an *a*-axis or *b*-axis oriented film, activity of the surface of the thin film being deposited lowers, so that the thin film becomes difficult to absorb or capture oxygen which contributes to formation of the superconductor. As a result, the superconducting property of the finally obtained compound oxide superconducting thin film deteriorates.

On the contrary, in the deposition process in accordance with the present invention, an auxiliary laser beam is irradiated in parallel to the deposition surface so as to pass through the proximity of the deposition surface of the substrate during the course of deposition. By this treatment, the activity of oxygen in the atmosphere in the vicinity of the deposition surface is enhanced, so that a sufficient amount of oxygen is absorbed or captured in the thin film. As a result, that the superconducting property of the finally obtained compound oxide superconducting thin film is improved.

For example, the film deposition of an Y-Ba-Cu-O compound oxide will be described. In the case of depositing a superconducting thin film in accordance with the process of the present invention, the critical temperature of the obtained thin film does not drop even if the substrate temperature is lowered to about 600°C. In the case of the Y-Ba-Cu-O compound oxide superconductor, since it is said that a suitable substrate temperature for depositing an *a*-axis or *b*-axis oriented thin film is about 650°C, it is possible to deposit an *a*-axis or *b*-axis oriented thin film having an extremely good superconducting property, in accordance with the deposition process of the present invention.

Further, in one preferred embodiment of the present invention, it is advantageous to perform the evaporation treatment by swinging an auxiliary laser beam while maintaining the auxiliary laser beam in parallel to the substrate, so that the above mentioned effect of the auxiliary laser beam is uniformly distributed over the whole of the thin film.

In addition, in order to obtain a distinct effect of the auxiliary laser beam used in the deposition process in accordance with the present invention, the energy given by the auxiliary laser beam must be not less than a certain degree. Specifically, for example, if an ArF excimer laser having a wavelength of 193 nm is used as the auxiliary laser beam, it is preferable that the energy density is not less than 1 mJ/cm² and that the repetition frequency is not less than 10 Hz. In other words, if the auxiliary laser beam does not meet this condition, almost no effect of using the auxiliary laser beam can be obtained.

The substrate, on which the oxide superconducting thin film is deposited, can be formed of a material selected from the group consisting of MgO, SrTiO₃, NdGaO₃, Y₂O₃, LaAlO₃, LaGaO₃, Al₂O₃, and ZrO₂. However, the material for the oxide insulator thin film is not limited to these materials, and the oxide insulator thin film can be formed of any oxide material which does not diffuse into the high-Tc copper-oxide type oxide superconductor material used, and which substantially matches in crystal lattice with the high-Tc copper-oxide type oxide superconductor material used, so that a clear boundary is formed between the oxide insulator thin film and the superconducting layer of the high-Tc copper-oxide type oxide superconductor material. From this viewpoint, it can be said to be possible to use an oxide insulating material conventionally used for forming a substrate on which a high-Tc copper-oxide type oxide superconductor material is deposited.

A preferred substrate includes a MgO single crystal, a SrTiO₃ single crystal, a NdGaO₃ single crystal substrate, a Y₂O₃, single crystal substrate, a LaAlO₃ single crystal, a LaGaO₃ single crystal, a Al₂O₃ single crystal, and a ZrO₂ single crystal.

The above and other objects, features and advantages of the present invention will be apparent from the following description of preferred embodiments of the invention with reference to the accompanying drawings.

### Brief Description of the Drawings

Figure 1is a diagrammatic view illustrating a structure of a film depositing apparatus capable of performing a process in accordance with the present invention for depositing a film;
Figure 2 is a graph illustrating the X ray diffraction of Sample ① deposited in accordance with the process of the present invention;
Figure 3 is a graph illustrating the X ray diffraction of Sample ② deposited in accordance with the process of the present invention; and
Figure 4 is a graph illustrating the X ray diffraction of Sample ③ deposited in accordance with the conventional process for depositing a film.

### Description of the Preferred embodiments

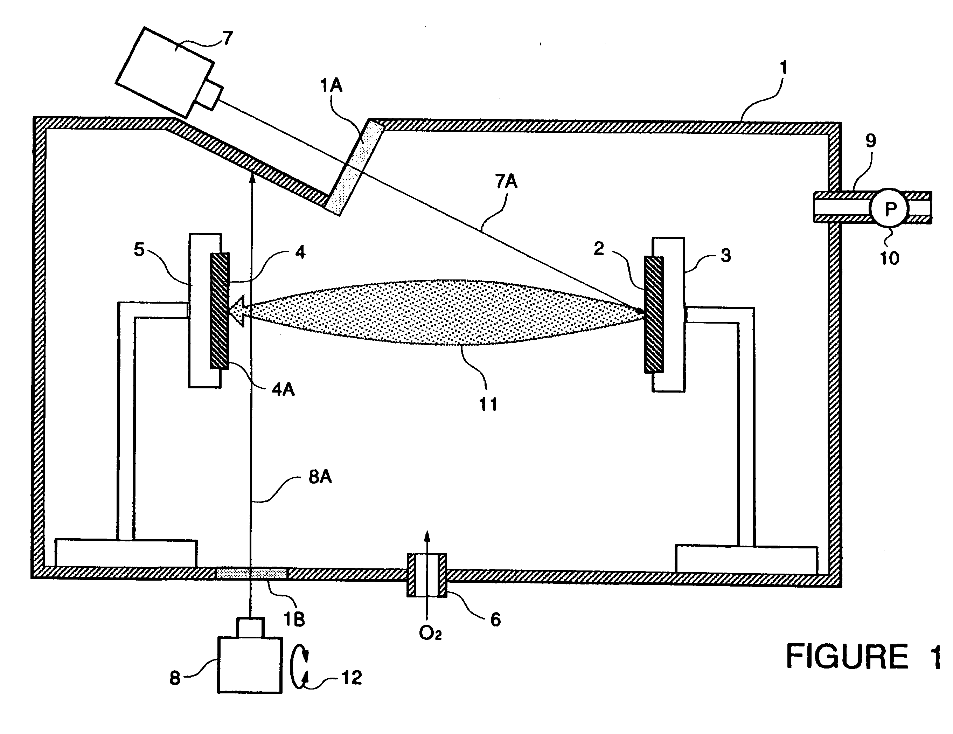

Figure 1 is a diagrammatic view illustrating the structure of an apparatus capable of performing the process in accordance with the present invention for depositing a film.

As shown in Figure 1, the film depositing apparatus essentially comprises a vacuum vessel 1 defining a reaction chamber therein. The vacuum vessel 1 has a pair of transparent windows 1A and 1B, which are positioned at mutually opposing places, respectively as shown in Figure 1. In addition, a target holder 3 and a substrate holder 5 are located in the vacuum vessel 1 in such a manner that a target 2 held by target holder 3 is positioned to oppose directly to a substrate held by the substrate holder 5. A pair of laser devices 7 and 8 are located at the outside of the vacuum vessel 1 so as to irradiate a laser beam in the vacuum vessel 1 through the windows 1A and 1B. Further, an oxygen introducing hole 6 for introducing oxygen gas into the vacuum vessel 1 is formed in the vacuum vessel 1, and an exhausting hole 9 is also provided in the vacuum vessel 1 and connected to an vacuum pump 10. At least one inlet/outlet for feeding the target 2 and the substrate 4 into the vacuum vessel 1 and for taking out the target 2 and the substrate 4 into the vacuum vessel 1 is provided in the vacuum vessel 1, even if it not shown. Of course, the inlet/outlet can be hermetically sealed.

The window 1A is inclined to an external wall of the vacuum vessel 1 in such a way that the laser device 7 for ablation can irradiate a main laser beam 7A to the target 2 held by the target holder 3. Further, the window 1B is placed in the vicinity of a position directly under the substrate 4 held by the substrate holder 5 in such a way that the auxiliary laser device 8 can irradiate an auxiliary laser beam 8A in parallel to the deposition surface of the substrate 4.

In order to perform the process of the present invention, the above mentioned film depositing apparatus is operated as follows:

First, a target 2 and a substrate 4 are set in the target holder 3 and a substrate holder 5, respectively. Then, after exhausting the vacuum vessel 1 by the vacuum pump 10, an adequate amount of oxygen is introduced in the vacuum vessel 1 through the oxygen introducing hole 6. Thereafter, while the vacuum vessel 1 is exhausted by the vacuum pump 10, oxygen is introduced into the vacuum vessel 1 through the oxygen introducing hole 6, so that a partial pressure of oxygen is maintained at a predetermined value. At this condition, the auxiliary laser device 8 is driven to irradiate the laser beam 8A in parallel to a deposition surface 4A of the substrate 4 in the vicinity of the deposition surface 4A of the substrate 4 so that the oxygen gas is excited in the vicinity of the deposition surface 4A of the substrate 4. At the same time, the laser device 7 for ablation is driven to irradiate the laser beam 7A to the target 2, so that a gas 11 of the material of the target 2 is evaporated from the target 2 by the main laser beam 7A and emitted toward the deposition surface 4A of the substrate 4, whereby a thin film is deposited on the the deposition surface 4A of the substrate 4.

With the operation as mentioned above, a laser deposition is effected in the presence of active oxygen within this film depositing apparatus. Thus, a thin film deposited on the substrate 4 can absorb or capture oxygen efficiently.

In the above mentioned evaporation treatment, the auxiliary laser beam 8A can be preferably swinged as shown in an arrow 12 in Figure 1 while maintaining the auxiliary laser beam in parallel to the substrate, so that the oxygen exciting effect of the auxiliary laser beam is uniformly distributed over the whole of the thin film.

### Manufactured Example

A Y-Ba-Cu-O compound oxide superconductor thin film is formed by a laser deposition, using a SrTiO₃ single crystal substrate as a substrate. The conditions for depositing a film, common to each sample, are shown in Table 1.

**Table 1**

| | |
|---|---|
| Target | Y₁Ba₂Cu₃Oy |
| Oxygen gas pressure | 400 m Torr (53,33 Pa) |
| Distance between Substrate and Target | 50 mm |
| Laser for ablation | |
| Wavelength | 193 nm |
| Energy density | 1.5 J/cm² |
| Repetition frequency | 1 Hz |
| Auxiliary Laser | |
| Wavelength | 193 nm |
| Energy density | 10 mJ/cm² |
| Repetition frequency | 150 Hz |

In the above mentioned conditions for depositing a film, a sample ① was manufactured at a substrate temperature of 600°C, and a sample ② was manufactured at a substrate temperature of 650°C. For comparison, a sample ③ was manufactured without irradiation by the auxiliary laser.

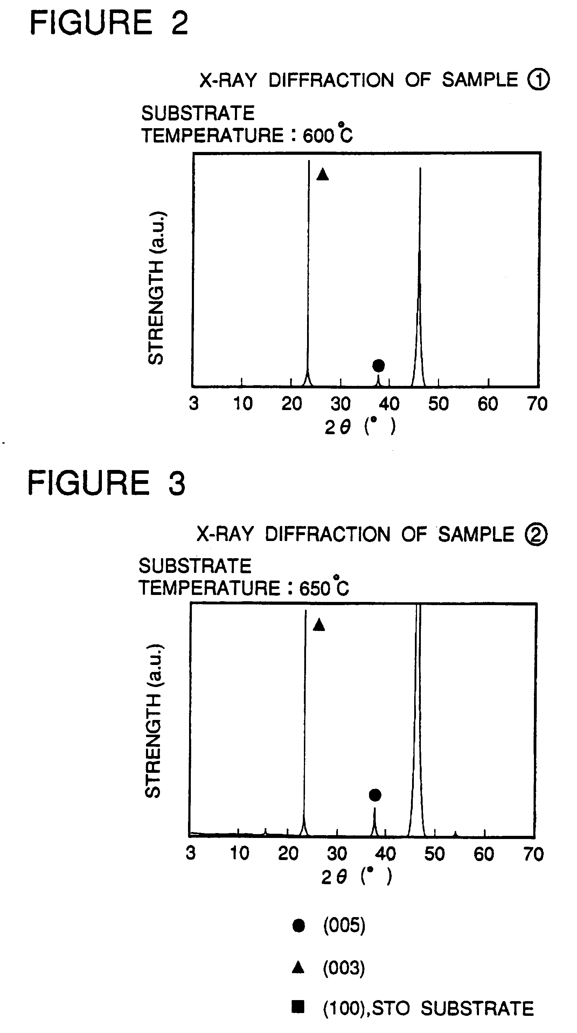

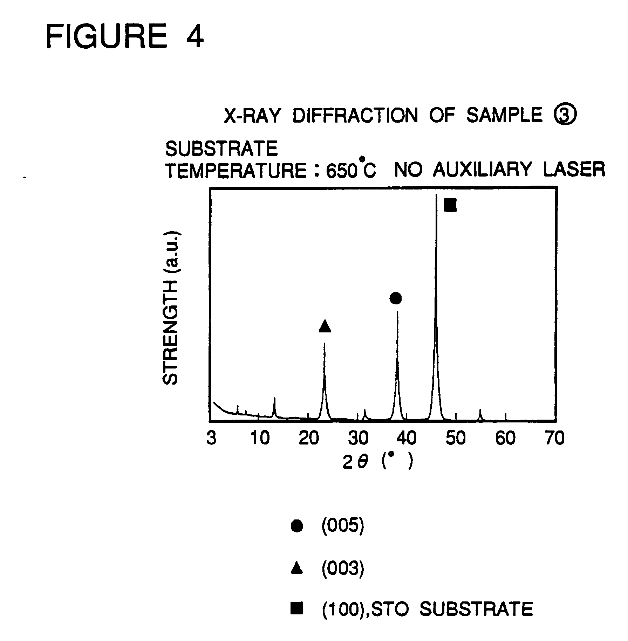

The film property of these samples were measured by X ray diffraction. The results are shown in graphs of Figures 2 to 4.

As shown in these figures, in the thin film deposited in accordance with the process of the present invention, a peak of a reflection by the (003) plane representing an *a*-axis orientation clearly appears in the samples ① and ②, and at the same time, a peak of a reflection by the (005) plane almost disappears. On the contrary, in the X ray diffraction of the sample ③ deposited without irradiation of the auxiliary laser, the peak of (005) is higher than the peak of (003).

Further, the superconducting critical temperature of the samples ① and ②, which are good *a*-axis oriented thin films as mentioned above, was measured. It was confirmed that the sample ① deposited at a substrate temperature of 600°C became a superconductor at a high critical temperature of 81°K, and the sample ② deposited at a substrate temperature of 650°C became a superconductor at a high critical temperature of 84°K. On the other hand, the *a*-axis oriented thin film of Y-Ba-Cu-O compound oxide superconductor, deposited in accordance with the conventional process for depositing a film, has a critical temperature of only 70°K.

In addition, since the excimer laser is in the form of a pulse having a continuous irradiation time width on the order of a few tens nanoseconds, the higher the repetition frequency of the excimer auxiliary laser becomes, the larger the applied energy becomes, and therefore, the activity of oxygen in the atmosphere in the vicinity of the deposition surface is furthermore enhanced. When the excimer laser is used, in the case that the energy density of the used auxiliary laser beam is less than 1 mJ/cm² and in the case that the repetition frequency of the auxiliary laser beam is less than 10 Hz, the finally obtained thin films had only the characteristics that are not significantly different from those of the film deposited without using the auxiliary laser beam.

In the above mentioned embodiment, a compound oxide superconducting thin film in which the crystal is oriented in an *a*-axis direction and which has a good superconducting property could be deposited by a laser evaporation or ablation. However, the use of the auxiliary laser passing in the vicinity of the deposition surface of the substrate, in parallel to the deposition surface of the substrate, is not limited to the laser evaporation or ablation, and can be applied to a sputtering process or other physical vapor deposition processes performed in oxygen atmosphere.

As mentioned above, the process in accordance with the present invention for depositing a film enables deposit at a low substrate temperature a thin film containing oxygen sufficiently. Accordingly, it is possible to deposit, by a laser deposition, a compound oxide superconducting thin film in which the crystal is oriented in an *a*-axis direction and which has a good superconducting property.

The invention has thus been shown and described with reference to the specific embodiments. However, it should be noted that the present invention is in no way limited to the details of the illustrated structures but changes and modifications may be made within the scope of the appended claims.

## Claims

**1-** A process for depositing a compound oxide superconducting thin film in a physical vapor deposition process, including the step of depositing a film on a deposition surface (4A) of a substrate (4) while in an oxygen atmosphere, by passing an auxiliary laser beam (8A) in the vicinity of said deposition surface (4A) of said substrate (4), in parallel to said deposition surface (4A) of said substrate (4).

**2-** A process as claimed in claim 1 wherein said auxiliary laser beam is an ArF excimer laser having a wavelength of 193 nm.

**3-** A process as claimed in claim 2, wherein the energy density of said auxiliary laser beam (8A) is not less than 1 mJ/cm².

**4-** A process as claimed in claims 2 or 3 wherein the repetition frequency of said auxiliary laser beam (8A) is not less than 10 Hz.

**5-** A process as claimed in any one claims 1 to 4 wherein said auxiliary laser beam is repeatedly swinged while maintaining the said auxiliary laser beam (8A) in parallel to said deposition surface (4A) of said substrate (4), so that the oxygen atmosphere is uniformly excited on the whole of said deposition surface of said substrate.

**6-** A process for depositing a compound oxide superconducting thin film by a laser evaporation, including the step of irradiating a main laser beam (7A) onto a target (2) of a compound oxide superconductor material held in a closed chamber which forms an oxygen atmosphere, so that the compound oxide superconductor material evaporated from said target (2) by said main laser beam (7A) is deposited on a deposition surface (4A) of a substrate (4) held in said closed chamber, and simultaneously passing an auxiliary laser beam (8A) in the vicinity of said deposition surface (4A) of said substrate (4), in parallel to said deposition surface (4A) of said substrate (4) is excited by said auxiliary laser beam (8A).

**7-** A process as claimed in claim 6 wherein said auxiliary laser beam (8A) is an ArF excimer laser having a wavelength of 193 nm.

**8-** A process as claimed in claim 7, wherein the energy density of said auxiliary laser beam (8A) is not less than 1 mJ/cm².

**9-** A process as claimed in claims 7 or 8 wherein the repetition frequency of said auxiliary laser beam (8A) is not less than 10 Hz.

**10-** A process as claimed in any one of claims 6 to 9 wherein said auxiliary laser beam (8A) is repeatedly swinged while maintaining the said auxiliary laser beam (8A) in parallel to said deposition surface (4A) of said substrate (4), so that the oxygen atmosphere is uniformly excited on the whole of said deposition surface (4A) of said substrate (4).

**11-** A method as claimed in any one of claims 6 to 10 wherein said compound oxide superconductor material is formed of a Y-Ba-Cu-O type compound oxide superconductor material.

**12-** A method claimed in any one of claims 6 to 11 wherein said substrate (4) is formed of a material selected from the group consisting of a MgO single crystal, a SrTiO₃ single crystal, a NdGaO₃ single crystal, a Y₂O₃ single crystal, a LaAl0₃ single crystal, a LaGaO₃ single crystal, a Al₂O₃ single crystal, and a ZrO₂ single crystal.
